# EUROPEAN PATENT APPLICATION

(11) **EP 4 847 932 A1**
(43) Date of publication of application: **02.12.2026**
(21) Application number: 25863813.9
(22) Date of filing: 08.07.2025
(51) Int. Cl.: G01R 31/367, G01R 31/36, G01R 31/396, G01R 31/382, G01R 19/165, G01R 19/12, B60L 58/10

(54) **ELECTRONIC DEVICE, RECORDING MEDIUM, AND METHOD FOR CALCULATING OUTPUT REDUCTION RATE OF BATTERY CELL**

(30) Priority: 03.09.2024 KR 20240119303
(71) Applicant: LG Energy Solution, Ltd., Seoul 07335 (KR)
(72) Inventor: YUN, Seongyun, Yeongdeungpo-gu, Seoul 07335 (KR); KO, Younghwi, Yeongdeungpo-gu, Seoul 07335 (KR)
(74) Representative: Plasseraud IP
(86) International application number: PCT/KR2025/009877
(87) International publication number: WO 2026/054283

(57) **Abstract**

An electronic device disclosed in the present document comprises: an information acquisition interface for acquiring time-series information related to voltage, current, temperature, and state of charge of a plurality of battery cells included in a battery pack; a memory; and a processor, wherein the processor can: calculate a first resistance of a first battery cell on the basis of the current and the voltage of the first battery cell; calculate a second resistance of the first battery cell on the basis of the temperature and the SoC of the first battery cell; calculate an instantaneous resistance increase rate of the first battery cell on the basis of the first resistance and the second resistance; calculate an average resistance increase rate of the first battery cell on the basis of a plurality of instantaneous resistance increase rates of the first battery cell, corresponding to respective time points; and calculate an output decrease rate of the first battery cell on the basis of the average resistance increase rate of the first battery cell.

## Description

### Technical Field

Example embodiments of the present disclosure relate to an electronic device, a recording medium, and a method of calculating an output reduction rate of a battery cell.

### Background Art

Recent years have seen active research and development in the field of secondary batteries. Here, the secondary battery refers to a rechargeable battery, including both conventional Ni/Cd batteries and Ni/MH batteries, as well as recent lithium-ion batteries. Among rechargeable batteries, the lithium-ion battery has an advantage of high energy density compared to the conventional Ni/Cd batteries and Ni/MH batteries. In addition, the lithium-ion battery may be produced to be compact and lightweight to serve as a power supply of portable devices, and as the usage has been widened to a power supply of a vehicle, the lithium-ion battery is in the limelight as a next generation energy storage medium.

To manage the quality of a battery installed in a vehicle, it is important to verify and diagnose battery data. Particularly, it is important to accurately estimate resistance of a battery depending on vehicle driving to determine an output reduction rate of a battery.

### Detailed Description of the Invention

### Technical Goals

According to an example embodiment of the present disclosure, a technical goal is to calculate a stable and accurate resistance increase rate by calculating resistance increase rate (or resistance reduction rate) using instantaneous resistance and estimated resistance in the beginning of life (BOL) state, without applying a filter to remove noise when measuring (or estimating) instantaneous resistance of a battery cell.

According to an example embodiment of the present disclosure, a technical is to minimize measurement errors caused by changes in state of charge (SoC) or temperature of a battery by applying a filter to remove noise to a resistance increase rate measured per driving cycle (in other words, battery charge and discharge cycle) of a vehicle.

According to an example embodiment of the present disclosure, a technical goal is to calculate an output reduction rate using a resistance increase rate of a battery cell.

Technical goals to be achieved by the example embodiments of the present disclosure are not limited to technical goals described above, and other technical goals may be inferred from example embodiments below.

### Technical solutions

An electronic device according to an example embodiment of the present disclosure may include an information acquisition interface that obtains time series information about voltage, current, temperature, and state of charge (SoC) of a plurality of battery cells included in a battery pack, a memory, and a processor. The processor may be configured to, based on current and voltage of the first battery cell, calculate first resistance of the first battery cell, based on temperature and SoC of the first battery cell, calculate second resistance of the first battery cell, based on the first resistance and the second resistance, calculate an instantaneous resistance increase rate of the first battery cell, based on a plurality of instantaneous resistance increase rates of the first battery cell corresponding to a plurality of time points, calculate an average resistance increase rate of the first battery cell, and based on the average resistance increase rate of the first battery cell, calculate an output reduction rate of the first battery cell.

The processor according to an example embodiment may be configured to identify whether the current exceeds a predetermined threshold value during a predetermined time, in response to the current exceeding the predetermined threshold value, calculate a voltage change and a current change during the predetermined time, and based on the voltage change and the current change, calculate the first resistance.

The processor according to an example embodiment may be configured to identify a resistance map of the first battery cell in a beginning of life (BOL) state, based on the resistance map, the temperature and the SoC of the first battery cell, calculate the second resistance. The resistance map may be a table representing resistance based on the temperature and the SoC of the first battery cell in the BOL state.

The processor according to an example embodiment may be configured to, based on the temperature of the first battery cell, determine whether a first measurement condition with regard to a temperature range is satisfied, based on the SoC of the first battery cell, determine whether a second measurement condition with regard to an SoC range is satisfied, and in response to whether the first measurement condition and the second measurement condition are satisfied, determine validity of the instantaneous resistance increase rate of the first battery cell.

The processor according to an example embodiment may be configured to, based on the temperature of the plurality of battery cells, determine whether a third measurement condition with regard to a temperature deviation is satisfied, based on the SoC of the plurality of battery cells, determine whether a fourth measurement condition with regard to an SoC error is satisfied, and in response to satisfying all of the first to the fourth measurement conditions, determine to calculate the instantaneous resistance increase rate of the first battery cell.

The processor according to an example embodiment may be configured to, by applying the plurality of instantaneous resistance increase rates and a valid decision value for the plurality of instantaneous resistance increase rates to a recursive average filter, calculate the average resistance increase rate of the first battery cell.

The processor according to an example embodiment may be configured to, based on a plurality of average resistance increase rates calculated at each of the plurality of time points, identify a maximum average resistance increase rate and a minimum average resistance increase rate, and, based on the maximum average resistance increase rate and the minimum average resistance increase rate, determine whether the average resistance increase rate of the first battery cell converges.

The processor according to an example embodiment may be configured to, when the average resistance increase rate of the first battery cell is determined to converge, based on the average resistance increase rate of the first battery cell, calculate the output reduction rate of the first battery cell.

The processor according to an example embodiment may be configured to calculate a plurality of output reduction rates of the first battery cell for each of a plurality of driving cycles of a vehicle including the battery pack.

The processor according to an example embodiment may be configured to, based on the plurality of output reduction rates, calculate a long-term output reduction rate of the first battery cell.

The processor according to an example embodiment may be configured to provide the long-term output reduction rate of the first battery cell to a vehicle.

The first resistance according to an example embodiment may indicate an instantaneous measured resistance of the first battery cell.

The second resistance according to an example embodiment may indicate an estimated resistance of the first battery cell in the BOL state.

A method of calculating an output reduction rate of a battery cell performed by an electronic device according to an example embodiment of the present disclosure, the method including, based on current and voltage of a first battery cell, calculating first resistance of the first battery cell, based on temperature and SoC of the first battery cell, calculating second resistance of the first battery cell, based on the first resistance and the second resistance, calculating an instantaneous resistance increase rate of the first battery cell, based on a plurality of instantaneous resistance increase rates of the first battery cell corresponding to a plurality of time points, calculating an average resistance increase rate of the first battery cell, and, based on the average resistance increase rate of the first battery cell, calculating an output reduction rate of the first battery cell.

According to an example embodiment of the present disclosure, in a computer-readable recording medium, recording a program for executing, on a computer, a method of calculating an output reduction rate of a battery cell, performed by an electronic device, the method of calculating the output reduction rate of the battery cell including, based on current and voltage of a first battery cell, calculating first resistance of the first battery cell, based on temperature and SoC of the first battery cell, calculating second resistance of the first battery cell, based on the first resistance and the second resistance, calculating an instantaneous resistance increase rate of the first battery cell, based on a plurality of instantaneous resistance increase rates of the first battery cell corresponding to a plurality of time points, calculating an average resistance increase rate of the first battery cell, and, based on the average resistance increase rate of the first battery cell, calculating an output reduction rate of the first battery cell.

### Effects of the Invention

According to an example embodiment of the present disclosure, it is possible to calculate a stable and accurate resistance increase rate by calculating a resistance increase rate (or a resistance reduction rate) using instantaneous resistance and estimated resistance in the beginning of life (BOL) state, without applying a filter to remove noise when measuring (or estimating) instantaneous resistance of a battery cell.

According to an example embodiment of the present disclosure, it is possible to minimize a measurement error caused by changes in state of charge (SoC) or temperature of a battery by applying a filter to remove noise to a resistance increase rate measured per driving cycle of a vehicle (in other words, battery charge and discharge cycle).

According to an example embodiment of the present disclosure, it is possible to calculate an output reduction rate using a resistance increase rate of a battery cell.

In addition, various effects directly or indirectly understood through this specification may be provided.

### Brief Description of Drawings

FIG. 1 is a block diagram of an electronic device according to an example embodiment of the present disclosure.
FIG. 2 is an operation flowchart of an electronic device according to an example embodiment of the present disclosure.
FIG. 3 is an operation flowchart of an electronic device according to an example embodiment of the present disclosure.
FIG. 4 is a graph illustrating a count of a valid instantaneous resistance reduction rate over time according to an example embodiment of the present disclosure.
FIG. 5 is a diagram illustrating distribution of an instantaneous resistance increase rate based on count according to an example embodiment of the present disclosure.
FIG. 6 is a diagram illustrating a graph showing a fluctuation of an average resistance increase rate based on count according to an example embodiment of the present disclosure.

### Mode for Carrying Out the Invention

Hereinafter, various example embodiments of the present disclosure will be described with reference to the accompanying drawings. It should be understood, however, that the present disclosure is not limited to specific example embodiments but includes various modifications, equivalents, and/or alternatives of example embodiments of the present disclosure.

In this specification, a singular form of a noun corresponding to an item may include one or more such items unless clearly indicated otherwise in context. In this specification, each of the expression "A or B," "at least one of A and B," "at least one of A or B," "A, B, or C," "at least one of A, B, and C," and "at least one of A, B, or C" may include any one of items or every possible combination thereof enumerated together in a corresponding expression. Terms such as "first" or "second" may be merely used to distinguish a corresponding an element from another element, and the terms do not limit the elements in another aspect (for example, importance or sequence). When it is mentioned that an (for example, a first) element is "coupled" or "connected" to another (for example, a second) element, with or without a term such as "functionally" or "communicatively," it indicates that the element may be connected to the another element directly (for example, through a wire), wirelessly, or through a third element.

Each element (for example, a module or a program) of elements described in this specification may include one or more instances. According to various example embodiments, one or more elements or operations among corresponding elements may be omitted or one or more other elements or operations may be added. Generally, or additionally, a plurality of elements (for example, a module or a program) may be integrated into one element. In this case, an integrated element may perform one or more functions of each element of the plurality of elements identically or similarly to what a corresponding element among the plurality of elements performs before integration. According to various example embodiments, operations performed by a module or a program or another element may be performed sequentially, in parallel, repeatedly, or heuristically, or one or more operations among the operations may be implemented in another order, omitted, or one or more other operations may be added.

The terms "module" or "unit" may include a unit implemented by hardware, software, or firmware, and may be used interchangeably with, for example, the terms such as logic, logic block, component, or circuit. A module may constitute an integrated component, or a minimum unit or a portion of the component that performs one or more functions. For example, according to an example embodiment, a module may be implemented in a form of an application-specific integrated circuit (ASIC).

Various example embodiments of this specification may be implemented by software (for example, a program or an application) including one or more commands stored in a storage medium (for example, a memory) readable by a machine. For example, a processor of a machine may call at least one command among one or more stored commands from a storage medium and implement the command. This enables a machine to be operated to perform at least one function by at least one called command. The one or more commands may include a code generated by a compiler or a code that may be executed by an interpreter. A storage medium readable by a machine may be provided in a form of a non-transitory storage medium. Here, "non-transitory" may merely indicate that a storage medium is a tangible device and does not include a signal (for example, an electromagnetic wave), and the term does not distinguish a case in which data is stored in a storage medium semi-permanently from a case in which data is stored in a storage medium temporarily.

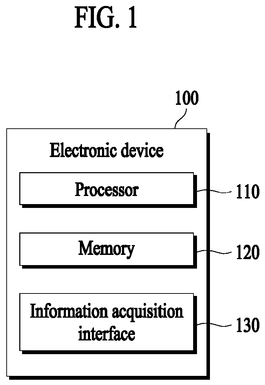

FIG. 1 is a block diagram of an electronic device 100 according to an example embodiment of the present disclosure. Referring to FIG. 1, the electronic device 100 may include a processor 110, a memory 120, and an information acquisition interface 130. At least one of elements included in the electronic device 100 may be omitted, or another element may be added to the electronic device 100. Additionally, or generally, some elements may be integrated to be implemented, or implemented as a singular or plural unity. At least some elements within the electronic apparatus 100 may be integrated to be implemented, or implemented as a singular or plural unity.

The electronic device 100 may diagnose a state of a plurality of battery cells included in a battery pack. The battery pack may include the plurality of battery cells arranged in series and/or in parallel. The battery pack may be configured in a unit of a battery module (or a battery bank), which is an assembly of battery cells. The battery pack may be installed in various devices, and installed in, for example, an electric vehicle.

The electronic device 100 may acquire voltage information and/or current information of the plurality of battery cells. The electronic device 100 may diagnose a state of each of the plurality of battery cells by calculating voltage relationship information (for example, an OCV-SOC profile) based on a state of charge of each of the plurality of battery cells or voltage relationship (for example, a capacity-voltage profile) based on capacity. The electronic device 100 may diagnose a state of a battery cell using battery field data.

The electronic device 100 may be a battery management device (or a battery management system (BMS)) included in the battery pack, an on-board diagnostics (OBD) device included in an electric vehicle, a server or a cloud device, or a charger-discharger and a charger.

The processor 110 of the electronic device 100 according to an example embodiment may be a configuration that may perform an operation about a control and/or communication of each element of the electronic device 100 or data processing, and may be functionally connected to elements of the electronic device 100. The processor 110 may load a command or data received from other elements of the electronic device 100 to the memory 120, process a command or data stored in the memory 120, and store result data. Unless otherwise specifically described, the processor 110 may refer to a set of one or more processors 110 in the present disclosure.

According to an example embodiment, the memory 120 of the electronic device 100 may store various data used by at least one element (for example, the processor 110). The memory 120 may store instructions with regard to an operation of the processor 110 described above. A program may be stored in the memory as software, and may include, for example, an operating system, middleware, or an application. Unless otherwise specifically described, the memory 120 may refer to a set of one or more memories 120 in the present disclosure.

The information acquisition interface 130 according to an example embodiment may acquire voltage information and/or current information of the plurality of battery cells included in the battery pack. The information acquisition interface 130 may acquire time-series information about voltage and current of the plurality of battery cells.

When the electronic device 100 is a BMS of the battery pack, the information acquisition interface 130 may be a configuration such as a sensor, measuring a state of the battery pack directly. In addition, when the electronic device 100 is an OBD device, a server, a cloud, or a charger-discharger, the information acquisition interface 130 may be a communication interface receiving measured information from a configuration (for example, the BMS of the battery pack) measuring a state of the battery pack.

The information acquisition interface 130 may acquire voltage information and/or current information of the plurality of battery cells included in the battery pack. Voltage information of the plurality of battery cells may refer to an operation voltage or an open circuit voltage (OCV) of each battery cell. For example, the information acquisition interface 130 may acquire an operation voltage of a battery cell during an operation of the battery pack and acquire an OCV of the battery cell in an idle state of the battery pack. In addition, current information of the battery cell may include a current of each battery cell and a current of a battery pack. The current of the battery pack and the current of each battery cell may be identical. The information acquisition interface 130 may acquire information about voltage and current of the battery pack continuously over time. For example, the information acquisition interface 130 may acquire voltage information and current information of the battery pack periodically. According to an example embodiment, the information acquisition interface 130 may acquire voltage information and current information of the plurality of battery cells in an over the air (OTA) manner. For example, the information acquisition interface 130 may acquire voltage information and current information of the battery cell from a BMS of the battery pack in the OTA manner.

The information acquisition interface 130 may acquire information about temperature and state-of-charge (SoC) of the plurality of battery cells included in the battery pack. The information acquisition interface 130 may acquire time-series information about temperature and SoC of the plurality of battery cells. Based on the information about voltage and/or current of the battery cell, the processor may determine (or estimate) information about SoC. Using an SoC estimating algorithm, the processor may calculate SoC using voltage and/or current information of the battery cell.

The processor 110 according to an example embodiment may calculate an instantaneous resistance of the battery cell based on current and voltage of the battery cell. The instantaneous resistance may refer to a measured resistance of the battery cell corresponding to a time point at which current and voltage are measured (in other words, a present time point). Based on the temperature and the SoC of the battery cell, the processor 110 may calculate an estimated resistance of the battery cell in the beginning of life (BOL) state. The estimated resistance may be an estimated resistance calculated using a resistance map of a first battery cell in the BOL state and current and voltage measured at the present time point. The BOL state may refer to information about a lifespan of a battery cell and a state at a time point at which the battery cell is produced and shipped.

The processor 110 according to an example embodiment may calculate an instantaneous resistance increase rate of the battery cell using an instantaneous resistance and an estimated resistance of the battery cell. The processor 110 may calculate a plurality of instantaneous resistance increase rates during a plurality of charge and discharge cycles and calculate an average resistance increase rate of the battery cell based on the plurality of instantaneous resistance increase rates. Based on the average resistance increase rate of the battery cell, the processor 110 may calculate an output reduction rate of the battery cell. Based on the output reduction rate of the battery cell, the processor 110 may diagnose whether the battery cell is abnormal.

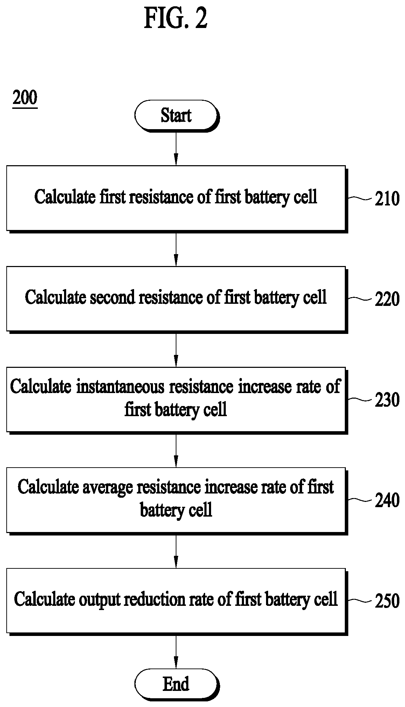

FIG. 2 is an operation flowchart of the electronic device 100 according to an example embodiment of the present disclosure.

Referring to an operation flowchart 200, the processor 110 of the electronic device 100 according to an example embodiment may calculate a first resistance of a first battery cell in operation 210. Based on current and voltage of the first battery cell, the processor 110 may calculate the first resistance of the first battery cell. The first resistance of the first battery cell may refer to an instantaneous resistance corresponding to a time point at which the current and the voltage of the first battery cell are measured. The first resistance may be ohmic resistance. The processor 110 may determine the first resistance of the first battery cell by calculating a slope (dV/dI) of a voltage-current graph of the first battery cell.

The processor 110 may determine the first resistance of the first battery cell using a tuning factor. The processor 110 may identify whether a current of the first battery cell exceeds a predetermined threshold value during a predetermined time. For example, the processor 110 may identify the current of the first battery cell exceeds 5A during 0.1 seconds. The predetermined time (for example, 0.1s) may be set short enough to measure the instantaneous resistance. The predetermined threshold value (for example, 5A) for a current may be set variably as a tuning factor. When a current exceeds a threshold value, the processor 110 may calculate the first resistance using the equation 1 below. The processor 110 may calculate a voltage change and a current change during the predetermined time in response to the current exceeding the threshold value. The processor 110 may calculate the first resistance based on the voltage change and the current change. [Equation 1] ${R}_{1} = \frac{Δ V}{Δ I} = \frac{{V}_{present} - {V}_{previous}}{{I}_{present} - {I}_{previous}}$

R₁ may be the first resistance, and ΔV may be the voltage change, and ΔI may be the current change. Vₚᵣₑₛₑₙₜ and Iₚᵣₑₛₑₙₜ may be voltage and current at a present time point, and Vₚᵣₑₛᵢₒᵤₛ and Iₚᵣₑᵥᵢₒᵤₛ may be voltage and current at a previous time point. A unit of the first resistance may be the ohm (Ω).

The previous time point and the present time point may differ by the predetermined time (for example, 0.1s). The present time point may be a time point after a current is changed more than a threshold value during the predetermined time, and the previous time point may be a time point before a current is changed more than the threshold value. Through the aforementioned manner, the processor 110 may calculate the first resistance, the instantaneous resistance of the first battery cell. In other words, the calculated first resistance may not be a value to which a filter (for example, the recursive least squares (RLS) algorithm) to remove noise is applied. In other words, as the first resistance may not be a value in which the instantaneous resistance is excessively stably tuned by applying a filter, a change of the instantaneous resistance based on a temperature change or an SoC change of the first battery cell may be tracked.

The processor 110 according to an example embodiment may calculate a second resistance of the first battery cell in operation 220. The second resistance may indicate an estimated resistance of the first battery cell in the BOL state. In other words, the second resistance may be a resistance identified by applying SoC and temperature measured at the present time point to the resistance map of the first battery cell in the BOL state. A unit of the second resistance may be the ohm (Ω). The processor 110 may identify the resistance map of the first battery cell in the BOL state. The resistance map may be stored in the memory 120 of the electronic device 100 or may be obtained from an external device (for example, a server) through the information acquisition interface 130. The resistance map may be a pre-defined table for the first battery cell in the BOL state and may be, for example, information such as the table below. The table below may be an exemplary table, and a resistance value included in the table may vary depending on a type of a battery cell. The processor 110 may identify a resistance value corresponding to temperature and SoC of the first battery cell using the resistance map and determine the identified resistance value as the second resistance of the first battery. For example, when the temperature of the first battery cell is 25 °C, and the SoC is 50 %, the processor 110 may determine the second resistance of the first battery cell as 1.000 Ω.

**[Table 1]**

| SoC | Temperature | | | | |
|---|---|---|---|---|---|
| | 0°C | 10°C | 25°C | 40°C | 60°C |
| 100% | 1.261Ω | 1.067Ω | 0.970Ω | 0.922Ω | 0.902Ω |
| 75% | 1.274Ω | 1.078Ω | 0.980Ω | 0.931Ω | 0.911Ω |
| 50% | 1.300Ω | 1.100Ω | 1.000Ω | 0.950Ω | 0.930Ω |
| 25% | 1.339Ω | 1.133Ω | 1.030Ω | 0.979Ω | 0.958Ω |
| 0% | 1.430Ω | 1.210Ω | 1.100Ω | 1.045Ω | 1.023Ω |

The processor 110 according to an example embodiment may calculate an instantaneous resistance increase rate of the first battery cell in operation 230. Based on the first resistance and the second resistance, the processor 110 may calculate the instantaneous resistance increase rate of the first battery cell. The processor 110 may calculate the instantaneous resistance increase rate using the equation 2 below. [Equation 2] ${SOHR}_{instant} = \frac{{R}_{1}}{{R}_{2}} ∗ 100$

SOHRᵢₙₛₜₐₙₜ may be the instantaneous resistance increase rate, and the unit may be percent (%). R₁ may be the first resistance, and R₂ may be the second resistance.

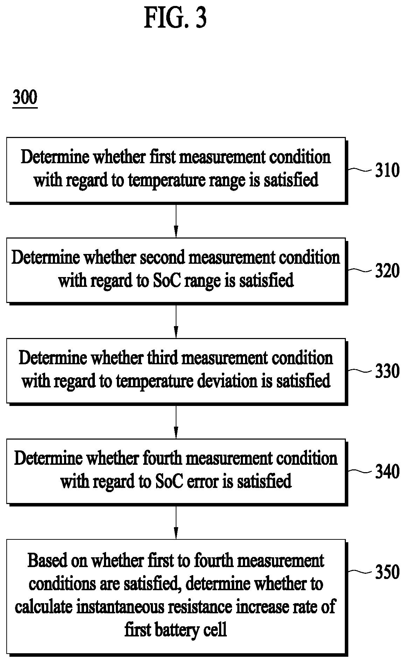

According to an example embodiment, when the first battery cell satisfies at least one measurement condition, the processor 110 may calculate the instantaneous resistance increase rate. At least one measurement condition may include a first measurement condition pertaining to a temperature range, a second measurement condition pertaining to an SoC range, a third measurement condition pertaining to a temperature deviation, or a fourth measurement condition pertaining to an SoC error. For example, when the first battery cell satisfies all of the first to fourth measurement conditions, the processor 110 may determine to calculate the instantaneous resistance increase rate. For example, when the first battery cell does not satisfy any one of the first to fourth measurement conditions, the processor 110 may determine not to calculate the instantaneous resistance increase rate. The first measurement condition to the fourth measurement condition may be conditions whether the first resistance measured for the first battery cell is reliable. FIG. 3 is an operation flowchart of the electronic device 100 according to an example embodiment of the present disclosure. Specifically, FIG. 3 may be an operation flowchart to determine whether to calculate the instantaneous resistance increase rate.

Referring to an operation flowchart 300, the processor 110 of the electronic device 100 according to an example embodiment may determine whether the first measurement condition pertaining to a temperature range is satisfied in operation 310. The first measurement condition may be a condition with regard to whether a temperature of the first battery cell is included within a predetermined temperature range. For example, the first measurement condition may be a condition with regard to whether the temperature of the first battery cell is greater than 10 °C and less than 50 °C. When the temperature of the first battery cell is included in the temperature range, the processor 110 may determine that the first measurement condition is satisfied. The aforementioned temperature range is exemplary and may be obviously changed depending on a tuning factor.

The processor 110 according to an example embodiment may determine that the second measurement condition pertaining to an SoC range is satisfied in operation 320. The second measurement condition may be a condition with regard to whether SoC of the second battery cell is included in a predetermined SoC range. For example, the second measurement condition may be a condition with regard to whether the SoC of the first battery cell is greater than 30 % and less than 90 %. When the SoC of the first battery cell is included in the SoC range, the processor 110 may determine that the second measurement condition is satisfied. The aforementioned SoC range is exemplary and may be obviously changed depending on a tuning factor.

The processor 110 according to an example embodiment may determine whether the third measurement condition pertaining to a temperature deviation is satisfied in operation 330. The third measurement condition may be a condition with regard to whether a temperature deviation determined based on temperature of a plurality of battery cells included in a battery pack is less than a predetermined threshold deviation. Here, the battery pack may refer to a battery pack including the first battery cell. For example, the third measurement condition may be a condition with regard to whether the temperature deviation determined above is less than 3 °C. The processor 110 may identify a maximum temperature and a minimum temperature among temperatures of the plurality of battery cells and determine a difference between the maximum temperature and the minimum temperature as the temperature deviation. The processor 110 may identify whether the determined temperature deviation is less than the threshold deviation. When the temperature deviation is less than the threshold deviation, the processor 110 may determine that the third measurement condition is satisfied. The aforementioned temperature deviation value is exemplary and may be obviously changed depending on a tuning factor.

The processor 110 according to an example embodiment may determine that the fourth measurement condition pertaining to an SoC error is satisfied in operation 340. The fourth measurement condition may be a condition with regard to whether an SoC error range determined based on SoC of a plurality of battery cells included in a battery pack is less than a predetermined threshold error value. Here, the battery pack may refer to a battery pack including the first battery cell. For example, the fourth measurement condition may be a condition with regard to whether the determined SoC error range is less than 3 %. Based on the SoC of the plurality of battery cells, the processor 110 may calculate the error range and identify whether the calculated error range is less than the predetermined threshold error. When the error range is less than the threshold error, the processor 110 may determine that the fourth measurement condition is satisfied. The aforementioned SoC range is exemplary and may be obviously changed depending on a tuning factor.

Based on whether the first to fourth measurement conditions are satisfied, the processor 110 according to an example embodiment may determine whether to calculate an instantaneous resistance increase rate of the first battery cell. When the first battery cell satisfies all of the first to fourth measurement conditions, the processor 110 may determine a valid decision value (Validᵢₙₛₜₐₙₜ) as true (T). When the Validᵢₙₛₜₐₙₜ is determined as T, the processor 110 may determine that the first resistance is reliable and to calculate the instantaneous resistance increase rate. Based on the first resistance and the second resistance, the processor 110 may calculate the instantaneous resistance increase rate.

When the first battery cell does not satisfy any one of the first to fourth measurement conditions, the processor 110 according to an example embodiment may determine a valid decision value (Validᵢₙₛₜₐₙₜ) as false (F). When the Validᵢₙₛₜₐₙₜ is determined as F, the processor 110 may determine that the first resistance is not reliable and not to calculate the instantaneous resistance increase rate.

Back to FIG. 2, the processor 110 according to an example embodiment may calculate an average resistance increase rate of the first battery cell in operation 240. Based on the plurality of instantaneous resistance increase rates of the first battery cell corresponding to a plurality of time points of the first battery cell corresponding to a plurality of time points, the processor 110 may calculate the average resistance increase rate of the first battery cell.

The processor 110 may calculate the average resistance increase rate of the first battery cell by applying the plurality of instantaneous resistance increase rates and a valid decision value of the plurality of instantaneous resistance increase rates corresponding to the plurality of time points to a recursive average filter. The processor 110 may add 1 to a count whenever a valid instantaneous resistance increase rate is calculated. For example, when a valid decision value is T, the processor 110 may add 1 to the count, and when a valid decision value is F, the processor 110 may not change the count. The processor 110 may calculate an average resistance increase rate of the first battery cell using the recursive average filter such as the equation 3 below. [Equation 3] ${SOHR}_{mean} = \frac{count - 1}{count} ∗ {SOHR}_{mean , prev} + \frac{1}{count} ∗ {SOHR}_{instant}$

SOHRₘₑₐₙ may be an average resistance increase rate at a present time point, a count may be a count, SOHR_{mean,prev} may be an average resistance increase rate at a previous time point, and SOHRᵢₙₛₜₐₙₜ may be an instantaneous resistance increase rate at a present time point. In other words, the processor 110 may calculate the average resistance increase rate by accumulating the valid instantaneous resistance increase rate sequentially, using the recursive average filter. A recursive average may refer to a technique adding one additional data based on the definition of an average, and may be different from a batch method that calculates an average all at once by collecting all data together.

The processor 110 according to an example embodiment may identify whether the average resistance increase rate converges. Based on the plurality of average resistance increase rates calculated at each of the plurality of time points, the processor 110 may identify a maximum average resistance increase rate and a minimum average resistance increase rate. Based on the maximum average resistance increase rate and the minimum average resistance increase rate, the processor 110 may determine whether the average resistance increase rate of the first battery cell converges.

When calculating the average resistance increase rate using the recursive average filter, the processor 110 may identify the plurality of average resistance increase rates at each of the plurality of time points, as the average resistance increase rate is calculated based on an accumulated valid average resistance increase rate at each time point. The processor 110 may identify the maximum average resistance increase rate (SOHR_{mean,max}) and the minimum average resistance increase rate (SOHR_{mean,min}) among the plurality of average resistance increase rates and calculate difference between the maximum average resistance increase rate and the minimum average resistance increase rate. The processor 110 may identify whether the difference between the maximum average resistance increase rate and the minimum average resistance increase rate is less than a predetermined convergence decision value (for example, 2.5). When the difference between the maximum average resistance increase rate and the minimum average resistance increase rate is less than the convergence decision value, the processor 110 may determine that the average resistance increase rate converges and determine a convergence flag value to be true (T). When the difference between the maximum average resistance increase rate and the minimum average resistance increase rate is equal to or greater than the convergence decision value, the processor 110 may determine that the average resistance increase rate does not converge and determine the convergence flag value to be false (F).

The processor 110 according to an example embodiment may calculate an output reduction rate of the first battery cell in operation 250. When the average resistance increase rate of the first battery cell is determined to converge, the processor 110, based on the average resistance increase rate of the first battery cell, may calculate the output reduction rate of the first battery cell. When the convergence flag value is F, the processor 110 may determine that the average resistance increase rate of the first battery cell does not yet converge and determine not to calculate the output reduction rate of the first battery cell. When the convergence flag value is T, the processor 110 may determine that the average resistance increase rate of the first battery cell converges and determine to calculate the output reduction rate of the first battery cell. The processor 110 may calculate the output reduction rate of the first battery cell using the equation 4 below. [Equation 4] ${SOHP}_{st} = \frac{100}{{SOHR}_{mean}} ∗ 100$

SOHPₛₜ may be an output reduction rate whose unit is percent (%), and SOHRₘₑₐₙ may be an average resistance increase rate whose unit is %.

The processor 110 according to an example embodiment may calculate a plurality of output reduction rates of the first battery cell for each of a plurality of driving cycles of a vehicle including the battery pack. The processor 110 may calculate and accumulate each of the plurality of output reduction rates during the plurality of driving cycles and calculate a long-term output reduction rate. For example, the processor 110 may calculate 20 output reduction rates during recent 20 driving cycles, accumulate the 20 output reduction rates, and calculate a long-term output reduction rate. The long-term output reduction rate may be an average value of the plurality of output reduction rates. The long-term output reduction rate may be an average value of the remaining output reduction rates, excluding a maximum output reduction rate and a minimum output reduction rate among the plurality of output reduction rates.

The processor 110 according to an example embodiment may provide the long-term output reduction rate to a vehicle. The processor 110 may transmit the long-term output reduction rate to an electronic control unit (ECU) of a vehicle through a communication interface (for example, a controller area network (CAN) communication module or a local interconnect network (LIN) communication module).

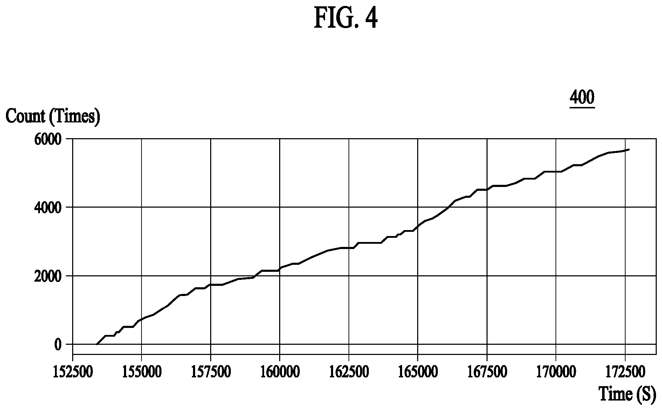

FIG. 4 is a graph 400 illustrating a count of a valid instantaneous resistance decrease rate over time according to an example embodiment of the present disclosure.

Referring to FIG. 4, the processor 110 may calculate a plurality of instantaneous resistance reduction rates during one driving cycle. As described above, when at least one measurement condition is satisfied at a predetermined measurement time point, the processor 110 may determine that a first resistance calculated at a predetermined measurement time point is valid (in other words, determine a valid decision value as T) and determine to calculate the instantaneous resistance reduction rate. A count may refer to the number of times the valid decision value is determined as T. In other words, the count may refer to the number of times the instantaneous resistance reduction rate is calculated.

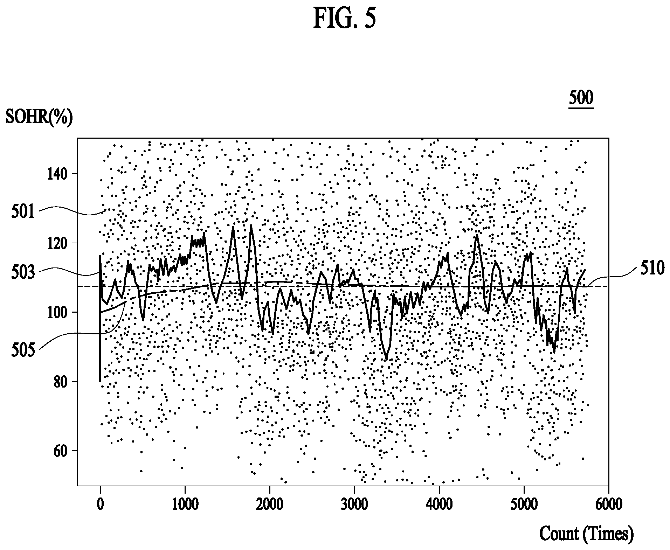

FIG. 5 is a diagram 500 illustrating distribution of an SOHR based on a count according to an example embodiment of the present disclosure.

Referring to FIG. 5, an SOHR value corresponding to each count may be marked as a dot 501, and an SOHR distribution based on a count may be identified. A graph 503 represented in a solid line may be a graph illustrating a plurality of instantaneous resistance increase rates calculated using a plurality of first resistances obtained at a plurality of time points after applying a filter (for example, an RLS filter or a moving average filter) to remove noise. When a noise removal filter is applied to the first resistance, a trend of the graph 503 may be identified unstable due to a change in resistance characteristics caused by changes in SoC and temperature of a battery cell.

Accordingly, according to various example embodiments of the present disclosure, a graph 505, represented by a single dashed line indicating the average resistance increase rate based on a stable trend count, may be obtained by calculating an instantaneous resistance increase rate using the first resistance without applying a noise removal filter to the first resistance, rather than the first resistance with the noise removal filter applied, and then applying a recursive average filter to a plurality of instantaneous resistance increase rates calculated at a plurality of time points to compute an average resistance increase rate. For example, during 1000 times of driving cycles, an instantaneous resistance increase rate may be measured and accumulated to be used for calculating an average resistance increase rate. With the recursive average filter applied, the trend of the graph 505 represented by the single dashed line may converge and become stable as counts accumulate. Referring to FIG. 5, it is identified that an average resistance increase rate converges to a convergence value 510 on the graph 505. The convergence value may be, for example, 109 %.

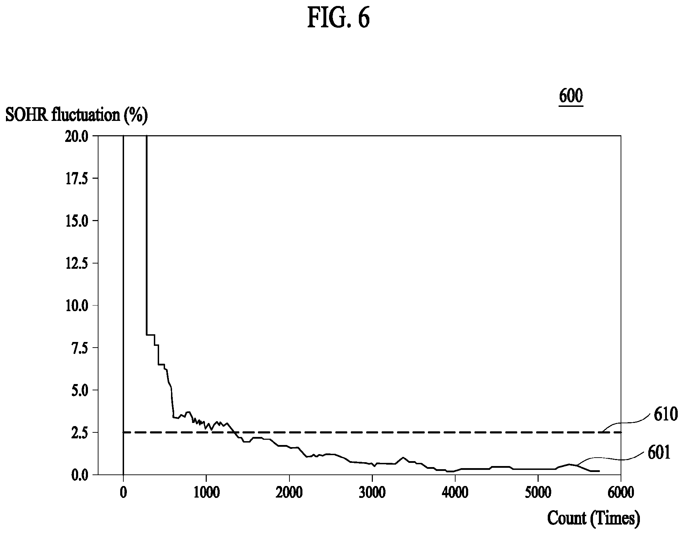

FIG. 6 is a diagram 600 illustrating a graph showing a fluctuation of an average resistance increase rate based on a count according to an example embodiment of the present disclosure.

Referring to FIG. 6, a graph 601 may be a graph illustrating a fluctuation of the average resistance increase rate during a recent predetermined period (for example, recent 300 counts). A convergence threshold value 610 represented by a dotted line may be, for example, 2.5 %. It is identified, through the graph 505 in FIG. 5, that the average resistance increase rate, calculated using a recursive average filter, converges as a count accumulates. Accordingly, it is identified that the fluctuation of the average resistance increase rate decreases through the graph 601.

Through the aforementioned process, an instantaneous resistance value that varies depending on temperature and SoC of a battery cell may be calculated to calculate an instantaneous resistance increase rate. By calculating an average resistance increase rate and an output reduction rate based on the instantaneous resistance increase rate, the dependency of the battery cell on temperature and SoC may be resolved, and the accuracy of a result value may be improved. As the opportunity to measure a first resistance, which is an instantaneous resistance, occurs frequently during a driving cycle of a vehicle, a large amount of resistance data may be accumulated in a short time, and a resistance increase rate and an output reduction rate may be converged to an estimated value in a short period of time.

The present specification and drawings have been described with respect to the example embodiments of the present disclosure. Although specific terms are used, it is only used in a general sense to easily explain the technical content of the present disclosure and to help the understanding of the invention, and is not intended to limit the scope of the specification. It will be apparent to those skilled in the art that other modifications based on the technical spirit of the present disclosure may be implemented in addition to the embodiments disclosed herein.

A device or a terminal in accordance with the above-described example embodiments may include a processor, a memory which stores and executes program data, a permanent storage such as a disk drive, a communication port for communication with an external device, and a user interface device such as a touch panel, a key, and a button. Methods realized by software modules or algorithms may be stored in a computer-readable recording medium as computer-readable codes or program commands which may be executed by the processor. Here, the computer-readable recording medium may be a magnetic storage medium (for example, a read-only memory (ROM), a random-access memory (RAM), a floppy disk, or a hard disk) or an optical reading medium (for example, a CD-ROM or a digital versatile disc (DVD)). The computer-readable recording medium may be dispersed to computer systems connected by a network so that computer-readable codes may be stored and executed in a dispersion manner. The medium may be read by a computer, may be stored in a memory, and may be executed by the processor.

Methods implemented by software or an algorithm disclosed in this specification may be implemented by a program and stored in a computer-readable recording medium (or a storage medium). A program may include computer-readable codes or program instructions to execute a plurality of steps. In an example embodiment, a recording medium may be implemented by a device, such as a server, a hard disk drive (HDD), a solid state drive (SSD), a read-only-memory (ROM), a random access memory (RAM), a CD-ROM, a magnetic tape, a floppy disk, or an optical data storage device. In an example embodiment, when a camera of a machine such as a computer identifies a QR code or a document, the QR code and the document may be regarded as recording media, and as such, recording medium is not limited to any particular type as long as being readable and executable by a computer. In an example embodiment, a program may be stored on a single recording medium, or may be distributed and stored across multiple recording media within a computer system connected through a network to enable distributed execution of a portion of the program.

In an example embodiment, a computer-readable recording medium may be provided as a non-transitory recording medium. Here, "non-transitory" may indicate that a recording medium is a type of device and not a temporary signal (for example, an electromagnetic wave), and the term is not intended to distinguish between cases in which data stored on the recording medium is stored permanently or temporarily. Meanwhile, it is merely an example embodiment, and the recording medium may also be modified and embodied as a transitory medium.

A method according to example embodiments may be included in a computer program product. The computer program product may be distributed in the form of a computer-readable medium (for example, a CD-ROM), distributed online through an application store (for example, by uploading and downloading), or directly distributed between two or more end devices. The method according to example embodiments may also be implemented as a computer program itself.

The present example embodiments may be represented by functional blocks and various processing steps. These functional blocks may be implemented by various numbers of hardware and/or software configurations that execute specific functions. For example, the present example embodiments may adopt direct circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, assembler, and Python including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor, for example.

## Claims

1. An electronic device, comprising:
an information acquisition interface that obtains time series information about voltage, current, temperature, and state of charge (SoC) of a plurality of battery cells included in a battery pack;
a memory; and
a processor,
wherein the processor is configured to,
based on current and voltage of a first battery cell, calculate first resistance of the first battery cell,
based on temperature and SoC of the first battery cell, calculate second resistance of the first battery cell,
based on the first resistance and the second resistance, calculate an instantaneous resistance increase rate of the first battery cell,
based on a plurality of instantaneous resistance increase rates of the first battery cell corresponding to a plurality of time points, calculate an average resistance increase rate of the first battery cell, and
based on the average resistance increase rate of the first battery cell, calculate an output reduction rate of the first battery cell.

2. The electronic device of claim 1,
wherein the processor is configured to
identify whether the current exceeds a predetermined threshold value during a predetermined time,
in response to the current exceeding the predetermined threshold value, calculate a voltage change and a current change during the predetermined time, and
based on the voltage change and the current change, calculate the first resistance.

3. The electronic device of claim 1,
wherein the processor is configured to
identify a resistance map of the first battery cell in a beginning of life (BOL) state,
based on the resistance map, the temperature and the SoC of the first battery cell, calculate the second resistance, and
wherein the resistance map is
a table representing resistance based on the temperature and the SoC of the first battery cell in the BOL state.

4. The electronic device of claim 1,
wherein the processor is configured to,
based on the temperature of the first battery cell, determine whether a first measurement condition with regard to a temperature range is satisfied,
based on the SoC of the first battery cell, determine whether a second measurement condition with regard to an SoC range is satisfied, and
in response to whether the first measurement condition and the second measurement condition are satisfied, determine validity of the instantaneous resistance increase rate of the first battery cell.

5. The electronic device of claim 4,
wherein the processor is configured to,
based on the temperature of the plurality of battery cells, determine whether a third measurement condition with regard to a temperature deviation is satisfied,
based on the SoC of the plurality of battery cells, determine whether a fourth measurement condition with regard to an SoC error is satisfied, and in response to satisfying all of the first to the fourth measurement conditions, determine to calculate the instantaneous resistance increase rate of the first battery cell.

6. The electronic device of claim 5,
wherein the processor is configured to,
by applying the plurality of instantaneous resistance increase rates and a valid decision value for the plurality of instantaneous resistance increase rates to a recursive average filter, calculate the average resistance increase rate of the first battery cell.

7. The electronic device of claim 6,
wherein the processor is configured to,
based on a plurality of average resistance increase rates calculated at each of the plurality of time points, identify a maximum average resistance increase rate and a minimum average resistance increase rate, and,
based on the maximum average resistance increase rate and the minimum average resistance increase rate, determine whether the average resistance increase rate of the first battery cell converges.

8. The electronic device of claim 7,
wherein the processor is configured to,
when the average resistance increase rate of the first battery cell is determined to converge, based on the average resistance increase rate of the first battery cell, calculate the output reduction rate of the first battery cell.

9. The electronic device of claim 1,
wherein the processor is configured to calculate a plurality of output reduction rates of the first battery cell for each of a plurality of driving cycles of a vehicle including the battery pack.

10. The electronic device of claim 1,
wherein the processor is configured to,
based on the plurality of output reduction rates, calculate a long-term output reduction rate of the first battery cell.

11. The electronic device of claim 1,
wherein the processor is configured to,
provide the long-term output reduction rate of the first battery cell to a vehicle.

12. The electronic device of claim 1,
wherein the first resistance indicates an instantaneous measured resistance of the first battery cell.

13. The electronic device of claim 1,
wherein the second resistance indicates an estimated resistance of the first battery cell in the BOL state.

14. A method of calculating an output reduction rate of a battery cell
performed by an electronic device, the method comprising:
based on current and voltage of a first battery cell, calculating first resistance of the first battery cell;
based on temperature and SoC of the first battery cell, calculating second resistance of the first battery cell;
based on the first resistance and the second resistance, calculating an instantaneous resistance increase rate of the first battery cell;
based on a plurality of instantaneous resistance increase rates of the first battery cell corresponding to a plurality of time points, calculating an average resistance increase rate of the first battery cell; and,
based on the average resistance increase rate of the first battery cell, calculating an output reduction rate of the first battery cell.

15. In a computer-readable recording medium, recording a program for executing, on a computer, a method of calculating an output reduction rate of a battery cell performed by an electronic device, the method of calculating the output reduction rate of the battery cell comprising:
based on current and voltage of a first battery cell, calculating first resistance of the first battery cell;
based on temperature and SoC of the first battery cell, calculating second resistance of the first battery cell;
based on the first resistance and the second resistance, calculating an instantaneous resistance increase rate of the first battery cell;
based on a plurality of instantaneous resistance increase rates of the first battery cell corresponding to a plurality of time points, calculating an average resistance increase rate of the first battery cell; and,
based on the average resistance increase rate of the first battery cell, calculating an output reduction rate of the first battery cell.
